(19) Europäisches Patentamt
European Patent Office
Office européen des brevets

(11) Publication number: **0 010 077**
**B1**

(12) # EUROPEAN PATENT SPECIFICATION

(45) Date of publication of patent specification: **01.09.82**

(51) Int. Cl.³: **H 03 L 7/06,** H 04 L 7/04

(21) Application number: **79850087.2**

(22) Date of filing: **21.09.79**

(54) **A method of and an arrangement for regulating the phase position of a controlled signal in relation to a reference signal in a telecommunication system.**

(30) Priority: **21.09.78 SE 7809934**

(43) Date of publication of application:
**16.04.80 Bulletin 80/8**

(45) Publication of the grant of the patent:
**01.09.82 Bulletin 82/35**

(84) Designated Contracting States:
**BE CH DE FR GB IT NL**

(56) References cited:
**DE - A - 2 735 053**
**US - A - 3 714 463**
**US - A - 4 001 713**

(73) Proprietor: **TELEFONAKTIEBOLAGET L M ERICSSON**
**S-126 25 STOCKHOLM (SE)**

(72) Inventor: **Andersson, Karl Arne Ingemar**
**Nolsjö**
**S-180 23 Ljusterö (SE)**
Inventor: **Roos, Sture Gösta**
**Box 9**
**S-760 10 Bergshamra (SE)**

(74) Representative: **Baumbach, Thorkild et al,**
**Telefonaktiebolaget L M Ericsson Patent Department**
**S-126 25 Stockholm (SE)**

**EP 0 010 077 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# A method of and an arrangement for regulating the phase position of a controlled signal in relation to a reference signal in a telecommunication system.

## Field of the Invention

The invention relates to a method for regulating the phase position of a controlled signal in relation to a reference signal in a telecommunication system and an arrangement for carrying out the method.

## Description of Prior Art

In a known technique, for example when phase detecting in phase locked loops, the phase difference between two signals is usually measured by starting the count pulses of known frequency at the positive edge of the reference signal and stopping the count at the positive edge of the controlled signal, the phase difference between the signals being determined by the number of pulses counted.

## Summary of the Invention

The disadvantage of this technique is that in order to obtain sufficient measuring precision the pulses must be of such a high frequency that such an arrangement is difficult to make in TTL-technology. Consequently, more complicated components are required, resulting in higher costs.

The method and the arrangement according to the invention which is characterized according to the claims, solves said problem and allows a very accurate detection of the phase difference between two signals by means of a few simple components, the measuring result being utilized for controlling the phase position of the first signal in relation to the phase position of the second signal.

In the arrangement according to the invention a code is obtained from the outputs of the flip-flops, stating the condition of the phase difference, that is, which one of the signals is before or after the other, and stating its magnitude only in so far as whether specified limits are exceeded or not. The latter, however, is detected with any desired precision. This is just what is needed for many applications.

An arrangement according to the invention can, for example, be utilized when controlling the different clocks included in an arrangement for majority choice of a clock signal so that the phase positions of the clocks will be as close together as possible.

The US Patent No 3 714 463 shows a detecting arrangement which expresses the phase difference in terms of a pulse width and not by means of complete digital signals. The arrangement provides a pulse width corresponding to leads or lags respectively, which implies however a dependence on the accuracy of the whole width of the pulses.

To the contrary with the arrangement and method of the invention it is possible to choose the wanted phase difference in the delay circuits as mentioned in the description. By choosing the delay, a detection can be carried out at an arbitrary phase difference within specified tolerance limits.

## Brief Description of the Drawings

The invention will be described more in detail, by way of example only with reference to the accompanying drawing, wherein:

Fig. 1 is a block diagram of an arrangement according to the invention; and

Figs. 2—5 are time diagrams explaining the operation of the arrangement for different phase differences between the signals.

## Preferred Embodiments

As is apparent from Fig. 1 an arrangement according to the invention contains two D-flip-flops FF1, FF2 of the type which, in the dependence on the phase difference between two signals fed to two of their inputs, produce an output signal of a high or a low level respectively. The flip-flops can for example be of the type, offered by TEXAS INSTRUMENTS under the designation 74S74.

To both these flip-flops are fed a reference signal C2 and a signal C1 to be controlled. The phase position of the signal C1 is to be regulated in relation to the phase position of the reference signal C2. The flip-flop FF1 receives on a first input a signal D1 which is the reference signal C2 delayed through a delay circuit DL1. On a second input the flip-flop FF1 receives the controlled signal C1 directly from a clock oscillator CL1.

The flip-flop FF2 receives on a first input a signal D2 which is the controlled signal C1 delayed through a delay circuit DL2 and receives on a second input the reference signal C2 directly. The delay circuits DL1 and DL2 are equal and consist of Schottky-buffers, for example. In the circuits DL1 and DL2 several buffers can be connected in series and the size of the delay in the circuits is determined by the number of buffers, which number can be chosen by clamping. The delay circuits can also consist of a delay line, the size of the delay then being determined by the length of the delay line.

When the phase difference between the reference signal C2 and the controlled signal C1 according to the example exceeds $\pm 5$ nano seconds a correction of the phase position of the signal C1 will be carried out to bring the phase difference back within these tolerance linits. The size of the tolerance limit can of course be changed by means of clamping, thus connecting different number of buffer stages in the delay circuits DL1, DL2. The output signals Q1 and Q2 from the flip-flops FF1 and FF2 respectively are set to their appropriate logic levels according to the phase differences between the signals C2 and C1 and are fed to the inputs of a logic circuit LC or a processor of known type, for example, a MOTOROLA M6900 micro processor.

The logic circuit LC produces a binary output signal which depends on the signal combination received on the inputs, which output signal after passing through a digital/analogue converter DA, controls the frequency of the oscillator CL1. The oscillator produces a signal C1 the phase position of which is corrected in relation to the reference signal C2.

Fig. 2—5 show the various logic levels of the signals Q1 and Q2 for various phase differences between the signals C2 and C1. The dashed lines in the figures mark the zero level line of the signals Q1 and Q2.

In fig. 2, the controlled signal C1 arrives at the input of flip-flop FF1 later than the delayed reference signal D1. The flip-flop FF1 produces an output signal Q1 of a high level as the first input of the flip-flop at the time of the comparison is occupied by a signal of high level. The flip-flop FF2, however, in this moment produces an output signal Q2 of a low level as the signal to the second input of the flip-flop in this case will precede the signal to the first input of the flip-flop FF2.

In fig. 3, the reference signal C2 arrives later than the delayed signal D2. The flip-flop FF1 is forced to produce an output signal Q1 at a low logic level while the flip-flop FF2 produces an output signal Q2 at a high logic level.

In fig. 4, the phase difference between the signals C2 and C1 is less than the delay between the signals C2 and D1. In this case both the signal Q1 and the signal Q2 take a low level.

In fig. 5, the phase difference between the positive edge of the signal C2 and the negative edge of the signal C1 is less than the delay between the signal C2 and the signal D1. In this case both the signal Q1 and the signal Q2 take a high level.

Thus various control signals are obtained of the four possible combinations of signals. In the first case the control signal obtained from the circuit LC increases the frequency of the clock oscillator CL1, in the second case the control signal decreases the frequency of the clock oscillator and in the third and the fourth cases no change of the frequency of the oscillator is obtained.

As appears from the description it is possible to detect phase differences both near 0 degrees and 180 degrees very accurately by means of the arrangement according to the invention.

**Claims**

1. A method for regulating the phase position of a controlled signal in relation to a reference signal in a telecommunication system, characterized in that the reference signal (C2) is delayed, the delayed reference signal (D1) is compared with the controlled signal (C1) to produce a first comparison signal (Q1) which is at a high or a low level respectively depending on the phase difference between the delayed reference signal (D1) and the controlled signal (C1), the controlled signal (C1) is delayed, the delayed controlled signal (D2) is compared with the reference signal (C2) to produce a second comparison signal (Q2) which is at a high and a low level respectively depending on the phase difference between the delayed controlled signal (D2) and the reference signal (C2), and a further signal is produced by logic circuitry, according to the logic levels of said first and second comparison signals (Q1 and Q2), said further signal being used as a control signal to correct the phase position of the controlled signal (C1) in relation to the phase position of the reference signal (C2).

2. An arrangement for regulating the phase position of a controlled signal in relation to a reference signal in a telecommunication system, characterized in that it comprises a first comparison circuit (FF1) of a type which in dependence on the phase difference between two signals fed to two of its inputs produces an output signal at a high and a low level respectively, said first comparison circuit having a first input connected to a first delay circuit (DL1) which is adapted to receive the reference signal and a second input which is adapted to receive the controlled signal (C1) directly, and a second comparison circuit (FF2), of the same type as the first comparison circuit (FF1), having a first input connected to a second delay circuit (DL2) which is adapted to receive the controlled signal (C1) and a second input which is adapted to receive the reference signal (C2) directly, and outputs of said first and second comparison circuits (FF1, FF2) being connected to a logic circuit (LC) for producing a control signal which depends on the logic levels of said outputs of said comparison circuits to correct the phase position of the controlled signal (C1) in relation to the phase position of the reference signal (C2).

3. An arrangement according to claim 2, characterized in that when the undelayed controlled signal (C1) arrives later than the delayed reference signal (D1), the first comparison circuit (FF1) produces an output signal (Q1) at a high level, and the second comparison circuit (FF2) produces an output signal (Q2) at a low level.

4. An arrangement according to claim 2, characterized in that when the reference signal (C2) arrives later than the delayed controlled signal (D2), the first comparison circuit (FF1) produces an output signal (Q1) at a low level, and the second comparison circuit (FF2) produces an output signal (Q2) at a high level.

5. An arrangement according to claim 2, characterized in that when the phase difference between the two undelayed signals (C2) and (C1) is less than the delay of the reference signal (C2), the output signals (Q1, Q2) of the first and second comparison circuits (FF1 and FF2) are at a low level.

6. An arrangement according to claim 2, characterized in that when the phase difference between a positive edge of the undelayed reference signal (C2) and a negative edge of the undelayed controlled signal (C1) is less than the delay of the reference signal (C2), the output signals (Q1, Q2) of the first and second comparison circuits (FF1 and FF2) are at a high level.

**Revendications**

1. Procédé pour régler la position de la phase d'un signal commandé par rapport à un signal de référence dans un système de télécommunication, caractérisé en ce que le signal de référence (C2) est retardé, le signal de référence retardé (D1) est comparé au signal commandé (C1) pour produire un premier signal de comparaison (Q1) qui est à un niveau haut ou à un niveau bas, respectivement, suivant la différence de phase entre le signal de référence retardé (D1) et le signal commandé (C1), le signal commandé (C1) est retardé, le signal commandé retardé (D2) est comparé au signal de référence (C2) pour produire un second signal de comparaison (Q2) qui est à un niveau haut et à un niveau bas, respectivement, suivant la différence de phase entre le signal commandé retardé (D2) et le signal de référence (C2), et un autre signal est produit par un circuit logique, en fonction des niveaux logiques desdits premier et second signaux de comparaison (Q1 et Q2), ledit autre signal étant utilisé comme signal de commande pour corriger la position de la phase du signal commandé (C1) par rapport à la position de la phase du signal de référence (C2).

2. Dispositif pour régler la position de la phase d'un signal commandé par rapport à un signal de référence dans un système de télécommunication, caractérisé en ce qu'il comporte un premier circuit de comparaison (FF1) d'un type qui, en fonction de la différence de phase entre deux signaux appliqués à deux ses entrées produit un signal de sortie à un niveau haut et à un niveau bas, respectivement, ledit premier circuit de comparaison ayant une première entrée connectée à un premier circuit à retard (DL1) qui est destiné à recevoir le signal de référence, et une seconde entrée qui est destinée à recevoir directement le signal commandé (C1), et un second circuit de comparaison (FF2), du même type que le premier circuit de comparaison (FF1), ayant une première entrée connectée à un second circuit à retard (DL2) qui est destiné à recevoir le signal commandé (C1), et une seconde entrée qui est destinée à recevoir directement le signal de référence (C2), et des sorties desdits premier et second circuits de comparaison (FF1, FF2) étant connectées à un circuit logique (LC) pour produire un signal de commande qui dépend des niveaux logiques desdites sorties desdits circuits de comparaison afin de corriger la position de la phase du signal commandé (C1) par rapport à la position de la phase du signal de référence (C2).

3. Dispositif selon la revendication 2, caractérisé en ce que le signal commandé non retardé (C1) arrive plus tard que le signal de référence retardé (D1), le premier circuit de comparaison (FF1) produit un signal de sortie (Q1) à un niveau haut, et le second circuit de comparaison (FF2) produit un signal de sortie (Q2) à un niveau bas.

4. Dispositif selon la revendication 2, caractérisé en ce que, lorsque le signal de référence (C2) arrive plus tard que le signal commandé retardé (D2), le premier circuit de comparaison (FF1) produit un signal de sortie (Q1) à un niveau bas, et le second circuit de comparaison (FF2) produit un signal de sortie (Q2) à un niveau haut.

5. Dispositif selon la revendication 2, caractérisé en ce que, lorsque la différence de phase entre les deux signaux non retardés (C2) et (C1) est inférieure au retard du signal de référence (C2), les signaux de sortie (Q1, Q2) des premier et second circuits de comparaison (FF1 et FF2) sont à un niveau bas.

6. Dispositif selon la revendication 2, caractérisé en ce que, lorsque la différence de phase entre un flanc positif du signal de référence non retardé (C2) et un flanc négatif du signal commandé non retardé (C1) est inférieure au retard du signal de référence (C2), les signaux de sortie (Q1, Q2) des premier et second circuits de comparaison (FF1 et FF2) sont à un niveau haut.

**Patentansprüche**

1. Verfahren zum Regulieren der Phasenstellung eines gesteuerten Signals in Beziehung zu einem Bezugssignal in einem Fernmeldenetz, dadurch gekennzeichnet, daß das Bezugssignal (C2) verzögert wird, das verzögerte Bezugssignal (D1) mit dem gesteuerten Signal (C1) verglichen wird, um ein erstes Vergleichssignal (Q1) zu erzeugen, das abhängig von der Phasendifferenz zwischen dem verzögerten Bezugssignal (D1) und dem gesteuerten Signal (C1) einen hohen bzw. einen niedrigen Pegel hat, das gesteuerte Signal (C1) verzögert wird, das verzögerte gesteuerte Signal (D2) mit dem Bezugssignal (C2) verglichen wird, um ein zweites Vergleichssignal (Q2) zu erzeugen, das abhängig von der Phasendifferenz zwischen dem verzögerten gesteuerten Signal (D2) und dem Bezugssignal (C2) einen hohen bzw. niedrigen Pegel hat, und durch Logikschaltkreise ein weiteres Signal gemäß den Logikpegeln des ersten und zweiten Vergleichssignals (Q1 und Q2) erzeugt wird, das als Steuersignal für die Korrektur der Phasenlage des gesteuerten Signals (C1) in Bezug zur Phasenlage des Bezugssignals (C2) dient.

2. Anordnung zum Regeln der Phasenlage eines gesteuerten Signals in bezug auf ein Bezugssignal in einem Fernsprechnetz, gekennzeichnet durch eine erste Vergleichsschaltung (FF1), die in Abhängigkeit von der Phasendifferenz zwischen zwei ihr an zwei Eingängen zugeführten Signalen ein Ausgangssignal mit H- bzw. L-Pegel erzeugt und deren erster Eingang mit einer ersten Verzögerungsschaltung (DL1) zur Aufnahme des Bezugssignals verbunden ist und deren zweiter Eingang das gesteuerte Signal (C1) direkt zugeführt erhält, und eine zweite Vergleichsschaltung (FF2) derselben Art wie die erste Vergleichsschaltung (FF1), deren erster Eingang mit einer zweiten Verzögerungsschaltung (DL2) verbunden ist, der das gesteuerte Signal (C1) zuführbar ist, während ihr zweiter Eingang das Bezugssignal (C2) direkt zugeführt erhält, während Ausgänge der ersten und zweiten Vergleichsschaltung (FF1, FF2) mit einer Logikschaltung (LC) zum Erzeugen eines Steuersignals verbunden sind, das von den Logikpegeln der Ausgänge der Vergleichsschaltungen abhängt, um die Phasenlage des gesteuerten Signals (C1) gegenüber der Phasenlage des Bezugssignals (C2) zu steuern.

3. Anordnung nach Anspruch 2, dadurch gekennzeichnet, daß die erste Vergleichsschaltung (FF1) ein Ausgangssignal (Q1) mit H-Pegel und die zweite Vergleichsschaltung (FF2) ein Ausgangssignal (Q2) mit L-Pegel erzeugt, wenn das unverzögerte Steuersignal (C1) nach dem verzögerten Bezugssignal (D1) eintrifft.

4. Anordnung nach Anspruch 2, dadurch gekennzeichnet, daß die erste Vergleichsschaltung (FF1) ein Ausgangssignal (Q1) mit L-Pegel und die zweite Vergleichsschaltung (FF2) ein Ausgangssignal (Q2) mit H-Pegel erzeugt, wenn das Bezugssignal (C2) später als das verzögerte gesteuerte Signal (D2) eintrifft.

5. Anordnung nach Anspruch 2, dadurch gekennzeichnet, daß die Ausgangssignale (Q1, Q2) der ersten und der zweiten Vergleichsschaltung (FF1, FF2) L-Pegel haben, wenn die Phasendifferenz zwischen den zwei verzögerten Signalen (C2, C1) geringer als die Verzögerung des Bezugssignals (C2) ist.

6. Anordnung nach Anspruch 2, dadurch gekennzeichnet, daß die Ausgangssignale (Q1, Q2) der ersten und der zweiten Vergleichsschaltung (FF1, FF2) H-Pegel haben, wenn die Phasendifferenz zwischen einer ansteigenden Flanke des unverzögerten Bezugssignals (C2) und einer abfallenden Flanke des unverzögerten Steuersignals (C1) kleiner als die Verzögerung des Bezugssignals (C2) ist.

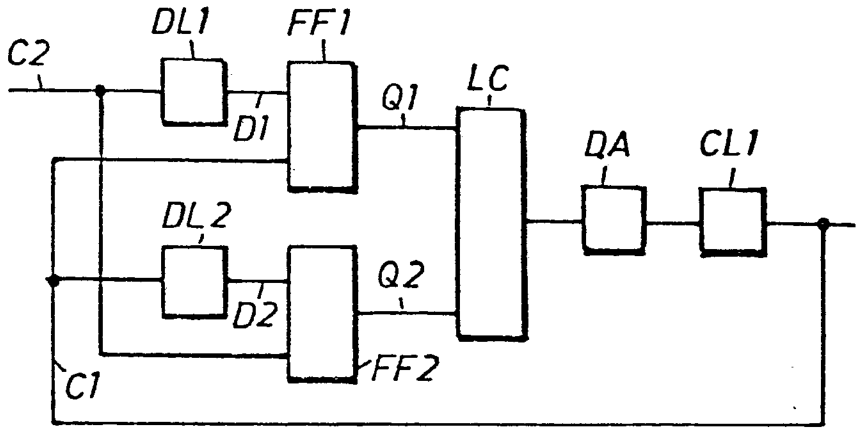


Fig. 1

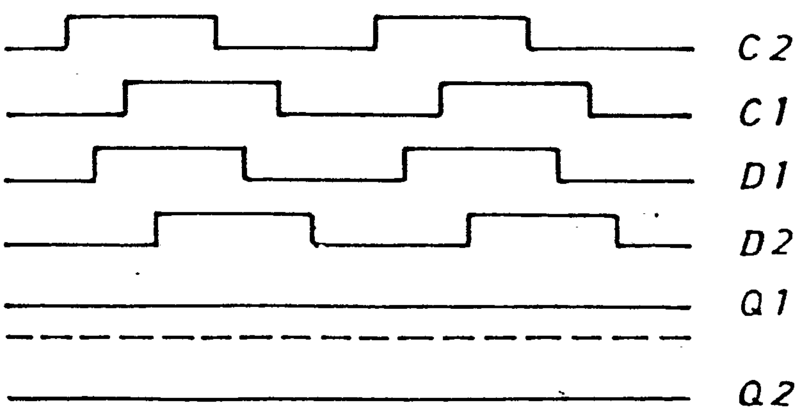


Fig. 2

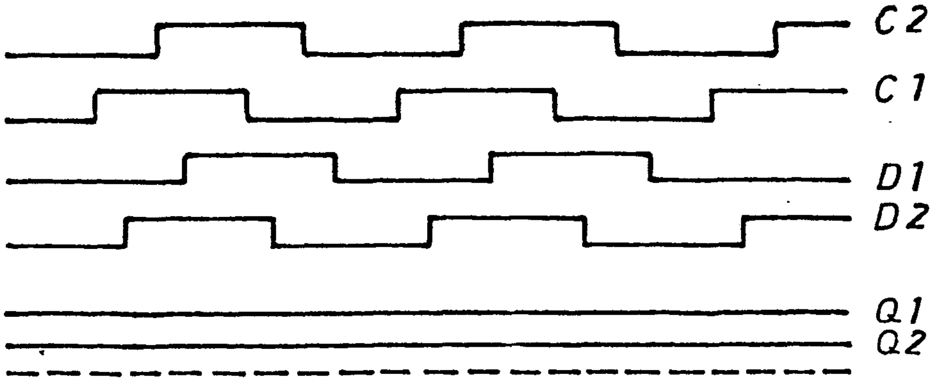


Fig 3

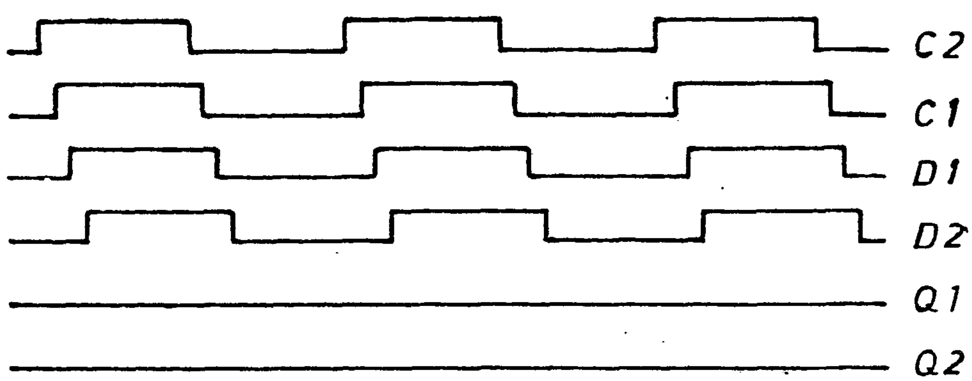


Fig. 4

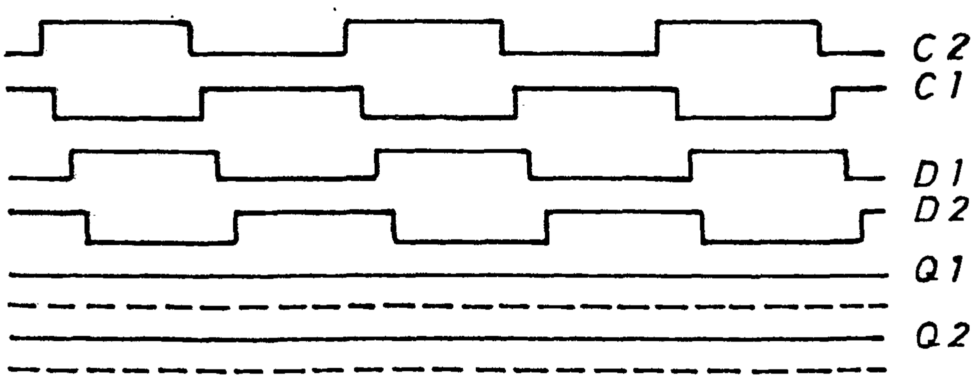


Fig. 5